**Europäisches Patentamt**

**European Patent Office**

**Office européen des brevets**

(19)

(11) Veröffentlichungsnummer: **0 357 111**
**A2**

(12) **EUROPÄISCHE PATENTANMELDUNG**

(21) Anmeldenummer: **89201975.3**

(22) Anmeldetag: **27.07.89**

(51) Int. Cl.5: **G01R 19/00**

(30) Priorität: **02.08.88 DE 3826214**

(43) Veröffentlichungstag der Anmeldung:
**07.03.90 Patentblatt 90/10**

(84) Benannte Vertragsstaaten:
**DE FR GB IT NL**

(71) Anmelder: **Philips Patentverwaltung GmbH**
**Wendenstrasse 35 Postfach 10 51 49**
**D-2000 Hamburg 1(DE)**

(84) **DE**

Anmelder: **N.V. Philips' Gloeilampenfabrieken**
**Groenewoudseweg 1**
**NL-5621 BA Eindhoven(NL)**

(84) **FR GB IT NL**

(72) Erfinder: **Siegbörger, Günther**
**Lornsenstrasse 131 G.**
**D-2000 Schenefeld(DE)**
Erfinder: **Horl, Manfred**
**Fehnweg 39**
**D-2000 Hamburg 62(DE)**

(74) Vertreter: **Hartmann, Heinrich, Dipl.-Ing. et al**
**Philips Patentverwaltung GmbH**
**Wendenstrasse 35 Postfach 10 51 49**
**D-2000 Hamburg 1(DE)**

(54) **Schaltungsanordnung zur Detektion von Spannungen aus mehreren Spannungsbereichen.**

(57) Die Erfindung betrifft eine Schaltungsanordnung zur Detektion von einem Schaltungseingang zugeführten Spannungen aus verschiedenen Spannungsbereichen, die wenigstens einen Differenzverstärker enthält, dessen einer Eingang mit dem Schaltungseingang gekoppelt ist und dessen anderer Eingang an eine Referenzspannung angeschlossen ist. Dadurch, daß eine Halbleiteranordnung, deren Hauptstrombahn ihn ihrer Leitfähigkeit durch einen zwischen ihrer Steuerelektrode und einem Anschluß der Hauptstrombahn angelegte Steuerspannung steuerbar ist, mit diesem Anschluß mit dem Schaltungseingang gekoppelt und mit ihrer Steuerelektrode an einen Versorgungsspannungsanschluß der Schaltung angeschlossen ist, derart, daß die Halbleiteranordnung ihren Leitfähigkeitszustand ändert, wenn das Potential am Schaltungseingang über das Potential an dem mit der Steuerelektrode verbundenen Versorgungsspannungsanschluß hinausgeht, kommt die Schaltung mit einer besonders niedrigen Versorgungsspannung aus.

FIG.1

## Schaltungsanordnung zur Detektion von Spannungen aus mehreren Spannungsbereichen

Die Erfindung betrifft eine Schaltungsanordnung zur Detektion von unterschiedlichen Spannungspegeln an einem Schaltungseingang mit einem ersten und einem zweiten Versorgungsspannungsanschluß.

Eine solche Schaltungsanordnung ist im wesentlichen aus der japanischen Patentanmeldung 59-212031 bekannt. Schaltungen dieser Art dienen dazu, einem von mehreren Spannungsbereichen am Eingang der Schaltung jeweils einen Logikzustand am Ausgang der Schaltung in definierter Weise zuzuordnen. Bei der bekannten Schaltung sollen vier verschiedene Spannungsbereiche detektiert werden; sie besitzt zu diesem Zweck drei Differenzverstärker, deren einer Eingang jeweils mit dem Schaltungseingang gekoppelt ist und deren anderer Eingang an einer Referenzspannung angeschlossen ist, wobei die drei Referenzspannungen die Spannungsbereiche festlegen. Um sicherzustellen, daß die Differenzverstärker durchschalten, müssen die Spannungsbereiche für die verschiedenen Logikzustände eingeschränkt werden. Dies führt dazu, daß eine derartige Schaltung nur bei Versorgungsspannungen oberhalb von 5 V zufriedenstellend arbeiten kann.

Aufgabe der vorliegenden Erfindung ist es, eine Schaltungsanordnung der eingangs genannten Art zu schaffen, die mit einer geringeren Versorgungsspannung auskommt. Diese Aufgabe wird erfindungsgemäß dadurch gelöst, daß die Schaltungsanordnung eine Halbleiteranordnung mit einer Steuerelektrode und einer Hauptstrombahn umfaßt, deren Leitfähigkeit durch eine Steuerspannung zwischen der Steuerelektrode und einem Hauptstrombahnanschluß steuerbar ist, und daß der Hauptstrombahnanschluß mit dem Schaltungseingang und die Steuerelektrode mit dem ersten Versorgungsspannungsanschluß gekoppelt ist, derart, daß sich die Leitfähigkeit der Hauptstrombahn ändert, wenn der Betrag der Spannung zwischen dem Schaltungseingang und dem zweiten Versorgungsspannungsanschluß größer wird als der Betrag der zwischen den beiden Versorgungsspannungsanschlüssen anliegenden Versorgungsspannung.

Die Halbleiteranordnung gestattet es, einen Spannungsbereich zu detektieren, der außerhalb des durch die Versorgungsspannung gegebenen Bereichs liegt. Wenn mit einer solchen Schaltung vier Spannungsbereiche detektiert werden sollen, sind daher nur noch zwei Differenzverstärker mit zwei verschiedenen Referenzspannungen erforderlich, um die übrigen drei Spannungsbereiche zu detektieren. Deshalb kann die Versorgungsspannung niedriger sein.

Eine Weiterbildung der Erfindung sieht vor, daß die Halbleiteranordnung ein Transistor ist, dessen Emitter mit dem Schaltungseingang gekoppelt und dessen Basis mit dem ersten Versorgungsspannungsanschluß verbunden ist. Diese Weiterbildung ist insbesondere für die Ausführung der Schaltung in integrierter Schaltungstechnik geeignet. Jedoch können die Halbleiteranordnungen grundsätzlich auch durch Feldeffekttransistoren, Thyristoren oder durch einen aus mehreren Transistoren bestehenden Schaltungsbaustein gebildet werden.

Um einen Spannungspegel innerhalb des Versorgungsspannungsbereiches detektieren zu können, sieht eine Weiterbildung der Erfindung vor, daß die Schaltung einen Differenzverstärker mit zwei Eingängen enthält und daß der eine Eingang mit dem Schaltungseingang gekoppelt ist und der andere Eingang einen Referenzspannungsanschluß bildet.

In weiterer Ausgestaltung ist vorgesehen, daß die Schaltungsanordnung einen weiteren Differenzverstärker enthält, dessen einer Eingang mit dem Kollektor des Transistors gekoppelt ist und dessen anderer Eingang einen weiteren Referenzspannungsanschluß bildet. Der weitere Differenzverstärker kann so gestaltet sein, daß der von ihm gelieferte Ausgangsstrom unabhängig von der Spannung am Schaltungseingang ist. Hingegen hängt der von den Transistor gelieferte Kollektorstrom von dieser Spannung ab.

Die Erfindung wird nachstehend anhand der Zeichnung näher erläutert. Es zeigen:

Fig. 1 eine erste Ausführungsform der Erfindung und

Fig. 2 eine verbesserte Ausführungsform.

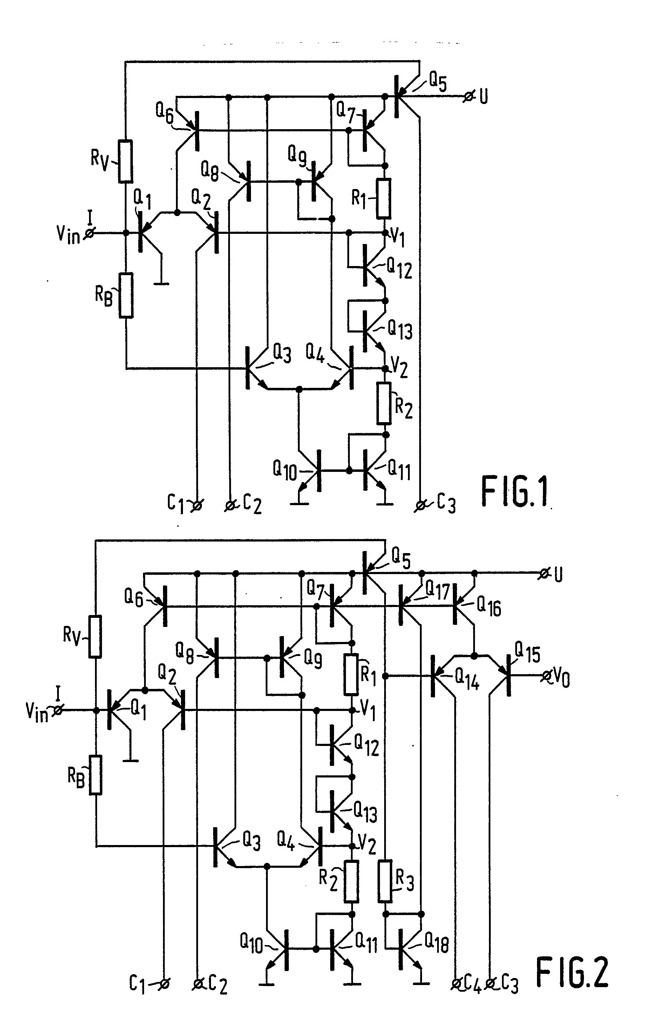

Die in Fig. 1 dargestellte Schaltung ist an eine Versorgungsspannung U angeschlossen, wobei die negative Versorgungsspannungsklemme mit Masse verbunden ist. Zwischen die Versorgungsspannungsklemmen ist eine Spannungsteilerkette geschaltet, die in der nachfolgend aufgezählten Reihenfolge folgende Elemente enthält:

Einen als Diode geschalteten NPN-Transistor $Q_{11}$, dessen Emitter mit Masse verbunden ist, einen Widerstand $R_2$ mit dem Wert R, als Dioden geschaltete NPN-Transistoren $Q_{12}$ und $Q_{13}$, einen Widerstand $R_1$, der ebenfalls die Größe R hat und R einen als Diode geschalteten PNP-Transistor $Q_7$, dessen Emitter mit der positiven Versorgungsspannungsklemme verbunden ist. Die als Diode geschalteten Transistoren $Q_{11}$ und $Q_7$ am Anfang bzw. am Ende der Spannungsteilerkette bilden den Eingang eines 1 : 1 Stromspiegels, der in bekannter Weise einen weiteren Transistor $Q_{10}$ bzw. $Q_6$ des gleichen Leitfähigkeitstyps umfaßt, dessen Basis-Emitter-Strecke der Basis-Emitter-Strecke

des Transistors $Q_{11}$ bzw. $Q_7$ parallel geschaltet ist. Der Ausgang des Stromspiegels $Q_6$, $Q_7$, d.h. der Kollektor des Transistors $Q_6$, ist mit den Emittern zweier PNP-Transistoren $Q_1$ und $Q_2$ verbunden. Der Kollektor des Transistors $Q_1$ ist an Masse angeschlossen, während der mit $C_1$ bezeichnete Kollektor des Transistors $Q_2$ einen der Ausgänge der Schaltung bildet. Die Basis des Transistors $Q_1$ ist mit dem Schaltungseingang I verbunden, an dem die zu detektierende Spannung $V_{in}$ anliegt. Die Basis des Transistors $Q_2$ ist an eine Referenzspannung $V_1$ angeschlossen, die aus der Spannungsteilerkette am Verbindungspunkt des Widerstandes $R_1$ und der Diode $Q_{12}$ abgegriffen wird. Sie liegt um die Durchlaßspannung eines pn-Überganges (ca. 0,7 V) höher als die Hälfte der Versorgungsspannung U.

Der Ausgang des Stromspiegels $Q_{10}$, $Q_{11}$, d.h. der Kollektor des Transistors $Q_{10}$ ist mit den Emittern zweier NPN-Transistoren $Q_3$ und $Q_4$ verbunden. Die Basis des Transistors $Q_3$ ist über einen Widerstand $R_B$ mit dem Schaltungseingang I verbunden, während an der Basis des Transistors $Q_4$ die Referenzspannung $V_2$ anliegt, die um eine Diodendurchlaßspannung unterhalb der Hälfte der Versorgungsspannung U liegt. Der Kollektor des Transistors $Q_3$ ist mit der positiven Versorgungsspannungsklemme verbunden, während der Kollektor des Transistors $Q_4$ mit einem als Diode geschalteten PNP-Transistor $Q_9$ verbunden ist, dessen Emitter an die positive Versorgungsspannungsklemme angeschlossen ist. Dieser Transistor bildet zusammen mit einem Transistor $Q_8$ gleichen Leitfähigkeitstyps einen Stromspiegel. Der Ausgang dieses Stromspiegels, d.h. der Kollektor $C_2$ des Transistors $Q_8$, bildet gleichzeitig einen Schaltungsausgang. Die den Emittern der Differenzverstärker $Q_1$, $Q_2$ bzw. $Q_3$, $Q_4$ zugeführten Gleichströme haben die gleiche Größe, weil diese Gleichströme vom Ausgang von Stromspiegeln geliefert werden, deren Eingänge vom gleichen Strom durchflossen werden.

Mit dem positiven Versorgungsspannungsanschluß ist die Basis eines Transistors $Q_5$ verbunden, dessen Emitter über einen Widerstand $R_V$ mit dem Eingang I der Schaltung und dessen Kollektor $C_3$ einen weiteren Schaltungsausgang bildet, der gegebenenfalls mit dem Ausgang $C_2$ verbunden sein kann.

Die Schaltung ermöglicht die Detektion von vier Spannungsbereichen. Es sei angenommen, daß die Versorgungsspannung U 5 V beträgt. Wenn die Spannung in einem ersten Spannungsbereich zwischen 0 V und 1,5 V liegt, sind die Transistoren $Q_2$ und $Q_5$ gesperrt, d.h. die Ausgänge $C_1$ und $C_3$ führen keinen Strom. Hingegen führt der Transistor $Q_4$ den gesamten vom Stromspiegel $Q_{10}$, $Q_{11}$ gelieferten Strom, der über den Stromspiegel $Q_8$, $Q_9$ am Ausgang $C_2$ erscheint.

In einem Spannungsbereich zwischen 2,1 V und 2,9 V sind die Transistoren $Q_2$ und $Q_5$ immer noch gesperrt, d.h. $C_1$ und $C_3$ sind stromlos. Jedoch wird dann der gesamte Emittergleichstrom des Differenzverstärkers $Q_3$, $Q_4$ über den Transistor $Q_3$ geführt, so daß auch $C_2$ stromlos ist.

Wenn die Eingangsspannung zwischen 3,5 V und 5 V liegt, fließt weiterhin der gesamte Strom des Differenzverstärkers $Q_3$, $Q_4$ über den Transistor $Q_3$, d.h. $C_2$ bleibt stromlos. Ebenso bleibt $C_3$ stromlos, weil der Transistor $Q_5$ gesperrt bleibt. Jedoch wird der Transistor $Q_2$ leitend, weil sein Basispotential negativer ist als das des Transistors $Q_1$, so daß $C_1$ Strom führt.

Wenn die Spannung am Eingang von I oberhalb von etwa 5,7 V liegt, bleiben die Transistoren $Q_2$ bzw. $Q_4$ leitend bzw. gesperrt. Jedoch wird der Transistor $Q_5$ leitend, d.h. am Ausgang $C_3$ fließt ein Strom.

Die Ströme an den Ausgängen $C_1$, $C_2$ und $C_3$, wobei $C_2$ und $C_3$ gegebenenfalls zusammengefaßt werden können, signalisieren somit, in welchem von vier Spannungsbereichen sich die Spannung $V_{in}$ am Schaltungseingang I jeweils befindet. - Anstelle des PNP-Transistors $Q_5$ könnte auch ein NPN-Transistor verwendet werden, wenn seine Basis mit dem negativen Versorgungsspannungsanschluß, d.h. mit Masse verbunden würde. In diesem Falle könnten allerdings keine Spannungen oberhalb der positiven Versorgungsspannung, sondern nur Spannungen unterhalb der negativen Versorgungsspannung detektiert werden, d.h. negative Spannung.

Im Gegensatz zu den Strömen an den Ausgängen $C_1$ und $C_2$ hängt der Ausgangsstrom des Transistors $Q_5$ von der Eingangsspannung ab, falls dieser einen Wert von 5,7 V überschreitet. Diese Abhängigkeit läßt sich durch die in Fig. 2 dargestellte Modifikation der Schaltung nach Fig. 1 beseitigen. Bei dieser Modifikation bildet der Kollektorstrom des Transistors $Q_5$ nicht unmittelbar den Ausgangsstrom, sondern er steuert eine Schaltung, die einen konstanten Ausgangsstrom liefert. - Davon abgesehen, hat die Schaltung den gleichen Aufbau wie die Schaltung nach Fig. 1.

Der Kollektorstrom des Transistors $Q_5$ wird der Serienschaltung eines Widerstandes $R_3$ und eines als Diode geschalteten NPN-Transistors $Q_{18}$, dessen Emitter mit Masse verbunden ist, zugeführt. Wenn der Widerstand $R_3$ die gleiche Größe hat wie der Widerstand $R_V$, dann ist die Potentialdifferenz zwischen dem positiven Versorgungsspannungsanschluß und dem Eingang I genauso groß wie die Spannung an der erwähnten Serienschaltung. Diese Spannung wird dem Eingang eines Differenzverstärkers zugeführt, der aus den beiden PNP-Transistoren $Q_{14}$ und $Q_{15}$ besteht. Die Basis des Tran-

sistors $Q_{14}$ ist mit der erwähnten Serienschaltung verbunden, während die Basis des Transistors $Q_{15}$ an eine Referenzspannung $V_0$ angeschlossen ist. Den miteinander verbundenen Emittern dieser Transistoren wird ein Strom von einem weiteren PNP-Transistor $Q_{16}$ geliefert, dessen Emitter mit der positiven Versorgungsspannungsklemme verbunden ist und dessen Basis mit der Basis des Transistors $Q_7$ verbunden ist, so daß der Transistors $Q_{16}$ einen weiteren Stromspiegelausgang bildet, der einen Strom von der gleichen Größe wie der Transistor $Q_6$ liefert.

Wenn $V_0$ mindestens 1 V beträgt, dann wird der Transistor $Q_{15}$ leitend, wenn die Spannung am Eingang I etwa um 0,3 V oberhalb der Summe von U und $V_0$ liegt. Am Kollektor $C_3$ des Transistors $Q_{15}$, der in diesem Fall auch mit $C_2$ verbunden sein könnte, fließt dann der gleiche Strom wie beispielsweise über den Ausgang $C_1$. Über den Kollektor $C_4$ des Transistors $Q_{14}$ fließt ein dazu komplementärer Ausgangsstrom.

Die Diode $Q_{18}$ wird durch den Kollektorstrom eines PNP-Transistors $Q_{17}$ vorgespannt, dessen Emitter mit der positiven Versorgungsspannungsklemme und dessen Basis mit der Basis des Transistors $Q_7$ verbunden ist, so daß der Kollektorstrom von $Q_{17}$ dem Kollektorstrom von $Q_6$ entspricht. Wenn die Referenzspannung $V_0$ kleiner ist als die Vorspannung an der Diode $Q_{18}$, kann der Differenzverstärker $Q_{14}$, $Q_{15}$ niemals umschalten, d.h. die Schaltung könnte Eingangsspannungen im höchsten Spannungsbereich nicht detektieren. Durch eine entsprechende Umschaltung der Referenzspannung $V_0$ könnte also diese Detektionsmöglichkeit abgeschaltet werden.

Der Gleichstrom für den Differenzverstärker $Q_{14}$, $Q_{15}$ muß nicht notwendigerweise von dem Transistor $Q_{16}$ geliefert werden. Wenn der Transistor $Q_2$ durch einen Multikollektortransistor ersetzt würde, dessen einer Kollektor (anstelle des Transistors $Q_{16}$) den Gleichstrom für die Transistoren $Q_{14}$ und $Q_{15}$ liefert, dann würde weder am Ausgang $C_3$ noch am Ausgang $C_4$ ein Strom fließen, solange die Spannung am Eingang I in einem der beiden unteren Spannungsbereiche liegt, wodurch der Multikollektortransistor gesperrt wäre. Eine solche Schaltungsmodifikation kann nützlich sein, wenn eine der Detektionsschaltung nachgeschaltete Steuerschaltung einen entsprechenden Verlauf der Steuersignale als Funktion des jeweiligen Spannungsbereichs am Eingang erfordern würde. Andernfalls wäre hierzu eine gesonderte Dekoderschaltung erforderlich.

Die beschriebene Schaltung kann Teil einer Integrierten Schaltung sein, die vom Ausgangssignal einer anderen Integrierten Schaltung gesteuert wird. Das Ausgangssignal dieser anderen Schaltung könnte in Abhängigkeit von einem Digitalsignal mit vier Logikpegeln bzw. zwei Binärstellen so gesteuert werden, daß sich für jeden Logikpegel eine analoge Spannung in einem der vier Spannungsbereiche ergäbe. Da die erfindungsgemäße Schaltung diese analoge Spannung wiederum in vier Logikpegel umsetzt, könnten diese auch direkt zwischen den beiden Schaltungen übertragen werden. Dies würde jedoch mindestens zwei Anschlüsse pro Integrierte Schaltung erfordern, während durch die Verwendung einer erfindungsgemäßen Detektionsschaltung nur jeweils ein äußerer Anschluß für die Übertragung erforderlich ist.

## Ansprüche

1. Schaltungsanordnung zur Detektion von unterschiedlichen Spannungspegeln an einem Schaltungseingang mit einem ersten und einem zweiten Versorgungsspannungsanschluß,
dadurch gekennzeichnet, daß die Schaltungsanordnung eine Halbleiteranordnung ($Q_5$) mit einer Steuerelektrode und einer Hauptstrombahn umfaßt, deren Leitfähigkeit durch eine Steuerspannung zwischen der Steuerelektrode und einem Hauptstrombahnanschluß steuerbar ist, und daß der Hauptstrombahnanschluß mit dem Schaltungseingang (I) und die Steuerelektrode mit dem ersten Versorgungsspannungsanschluß gekoppelt ist, derart, daß sich die Leitfähigkeit der Hauptstrombahn ändert, wenn der Betrag der Spannung zwischen dem Schaltungseingang und dem zweiten Versorgungsspannungsanschluß größer wird als der Betrag der zwischen den beiden Versorgungsspannungsanschlüssen anliegenden Versorgungsspannung (U).

2. Schaltungsanordnung nach Anspruch 1,
dadurch gekennzeichnet, daß die Halbleiteranordnung ein Transistor ($Q_5$) ist, dessen Emitter mit dem Schaltungseingang (I) gekoppelt und dessen Basis mit dem ersten Versorgungsspannungsanschluß verbunden ist.

3. Schaltungsanordnung nach einem der vorhergehenden Ansprüche
dadurch gekennzeichnet, daß die Schaltung einen Differenzverstärker ($Q_1$,$Q_2$) mit zwei Eingängen enthält und daß der eine Eingang mit dem Schaltungseingang (I) gekoppelt ist und der andere Eingang einen Referenzspannungsanschluß bildet.

4. Schaltungsanordnung nach Anspruch 2 oder 3,
dadurch gekennzeichnet, daß die Schaltungsanordnung einen weiteren Differenzverstärker enthält, dessen einer Eingang mit dem Kollektor des Transistors ($Q_5$) gekoppelt ist und dessen anderer Eingang einen weiteren Referenzspannungsanschluß bildet.

FIG.1

FIG.2

PHD 88-156